# EUROPÄISCHE PATENTANMELDUNG

(11) **EP 0 806 800 A1**
(43) Veröffentlichungstag der Anmeldung: **12.11.1997**
(21) Anmeldenummer: 97107080.0
(22) Anmeldetag: 29.04.1997
(51) Int. Cl.: H01L 29/92

(54) **Kondensator mit einer Carbid- oder Boridbarriereschicht**

(30) Priorität: 08.05.1996 DE 19618530
(71) Anmelder: SIEMENS AKTIENGESELLSCHAFT, 80333 München (DE)
(72) Erfinder: Schindler, Günther, Dr. Ing., 80802 München (DE); Bruchhaus, Rainer, Dr. Ing., 80997 München (DE)

(57) **Zusammenfassung**

Bei einem Kondensator, insbesondere mit einer hoch-ε-dielektrischen oder ferroelektrischen Schicht (10) als Kondensatordielektrikum, ist unterhalb des Kondensatordielektrikums (z. B. direkt unterhalb) eine Barriereschicht (9) vorgesehen, die im wesentlichen aus einer Verbindung zwischen einem Übergangselement und Bor oder Kohlenstoff besteht. Diese sauerstoffundurchlässige Barriereschicht (9) verhindert eine Oxydation tiefer liegender Strukturen bei Hochtemperaturprozessen, insbesondere bei der Herstellung des Kondensatordielektrikums.

## Beschreibung

Die Erfindung betrifft einen Kondensator in einer integrierten Schaltung, insbesondere in einem integrierten Halbleiterspeicher.

Zur Erzielung von Kondensatoren mit geringem Platzbedarf bei hoher Kapazität, wie sie beispielsweise in integrierten Halbleiterschaltungen benötigt werden, ist es bekannt, als Kondensatordielektrikum sogenannte Hoch-ε-Dielektrika oder Ferroelektrika und als Elektrode zum Beispiel Platin oder Roteniumoxyd (RuO₂) zu verwenden. Bei den Hoch-ε-Dünnschichten handelt es sich um Oxyde wie beispielsweise Strontiumtitanat und Bariumstrontiumtitanat mit typischen ε-Werten im Bereich von 200 - 600. Wie beispielsweise in Jpn. J. Appl. Phys. Vol. 34 (1995), S. 5224 - 5229 beschrieben, werden sie durch Hochtemperaturprozesse in einer sauerstoffhaltigen Atmosphäre hergestellt.

Zumindest die untere (erste) Elektrode, auf die das Dielektrikum aufgebracht wird, muß stabil unter diesen Bedingungen sein. Daher werden oft Platin- oder RuO₂-haltige Elektroden verwendet.

Diese Materialien sind jedoch sauerstoffdurchlässig, so daß die Oberfläche von angrenzenden Strukturen oxidieren könne. Wird wie üblich die erste Elektrode über eine Anschlußstruktur aus Polysilizium oder Wolfram mit anderen Schaltungselementen verbunden, oxidiert die Grenzschicht zwischen Anschlußstruktur und Elektrode, wodurch der Widerstand merklich erhöht wird oder eine elektrische Unterbrechung eintritt. Wird TiN als Silizium-Diffusionsbarriere unter der Elektrode eingesetzt, oxidiert dieses wahrend des Hochtemperaturprozesses, wie ebenfalls in Jpn. J. Appl. Phys. Vol. 34 (1995), S. 5224 - 5229 erläutert.

Aufgabe der Erfindung ist daher die Schaffung eines Kondensators mit hoher Kapazität bei geringem Platzbedarf, bei dem die genannten Probleme nicht auftreten. Diese Aufgabe wird durch die Merkmale der Patentansprüche 1 und 9 gelöst.

Die Erfindung beruht auf dem Einsatz einer Barriereschicht, die im wesentlichen aus einer Verbindung zwischen einem Übergangselement (3. - 8. Nebengruppe des Periodensystems) und Bor oder Kohlenstoff besteht. In diesen Substanzklassen existieren zahlreiche Materialien, die die Bedingungen: Leitfähigkeit und ausreichende Beständigkeit gegen Oxidation erfüllen, beispielsweise WB, WC, TiB, TiC, CrB, NbB und andere. Es können auch mehrere dieser Stoffe eingesetzt werden. Aufgrund ihrer Beständigkeit und des spezifischen Widerstandes von besonderem Interesse sind die folgenden Verbindungen:
TiC hat bei Raumtemperatur einen spezifischen Widerstand von 160 bis 200 uΩcm. Es ist an Luft bis 800°C stabil und zersetzt sich in O₂ erst bei 1150°C. Es wird von den meisten Säuren nicht angegriffen.
CrB hat bei Raumtemperatur einen spezifischen Widerstand von 64 uΩcm. Es bleibt beim Erhitzen in O₂ praktisch unverändert und ist sehr reaktionsträge.

Die Barriereschicht ist unterhalb des Kondensatordielektrikums und oberhalb der nächstfolgenden nichtoxidationsbeständigen Struktur angeordnet. Bei einer ggf. vorhandenen Anschlußstruktur ist sie vorzugsweise oberhalb dieser angeordnet, also zwischen Anschlußstruktur und erster Elektrode oder zwischen erster Elektrode und Kondensatordielektrikum. Bei einer Anschlußstruktur aus einem oxidationsbeständigen Material kann die Barriereschicht auch unterhalb dieser angeordnet sein, z. B. an der Grenzfläche zum Substrat. Wird auf eine Anschlußstruktur verzichtet, kann die Barriereschicht auch zwischen Elektrode und Substrat angeordnet sein.

Bei einer weiteren Ausführungsform besteht die erste Elektrode selbst aus der leitenden Barriereschicht.

In jedem Fall muß die Barriereschicht so angeordnet sein, daß bei der Herstellung des Kondensatordielektrikums Diffusionspfade für Sauerstoff wirksam unterbrochen sind.

Bei Einsatz in einer integrierten Halbleiterschaltung mit mehreren Kondensatoren dürfen benachbarte Kondensatoren nicht durch die Barriereschicht kurzgeschlossen werden, sie muß daher in geeigneter Weise strukturiert vorliegen.

Die Erfindung wird im folgenden anhand zweier Ausführungsbeispiele, die in den Zeichnungen dargestellt sind, naher erläutert.
- Figur 1: zeigt eine Speicherzelle einer integrierten Halbleiterschaltung mit einem Kondensator gemäß eines ersten Ausführungsbeispieles der Erfindung.
- Figur 2 und 3: zeigen weitere Ausführungsbeispiele.

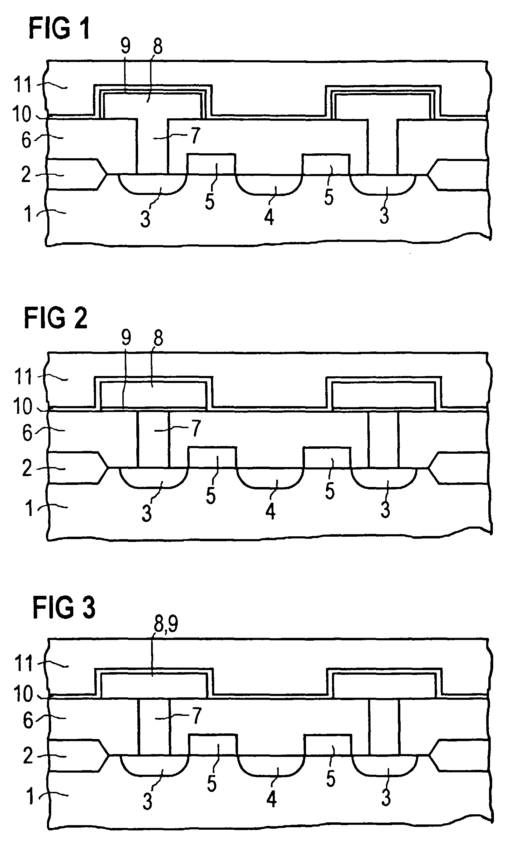

Figur 1: Als erstes Ausführungsbeispiel ist bei einem Kondensator in einem integrierten Halbleiterspeicher die Barriereschicht zwischen erster Elektrode und Kondensatordielektrikum angeordnet. Die Figur zeigt ein Substrat 1 mit einem darin angeordneten MOS-Transistor, der zwei S/D-Gebiete 3, 4 und ein isoliert auf dem Substrat aufgebrachtes Gate 5 umfaßt. Nichtaktive Bereiche der Schaltung sind mit einer Isolation 2 bedeckt. Eine Isolationsschicht 6 bedeckt den Transistor, wobei eine Anschlußstruktur 7 zum S/D-Gebiet 3 und einer außerhalb der Zeichenebene liegende Anschlußstruktur zum S/D-Gebiet 4 vorgesehen sind. In diesem Fall besteht die Anschlußstruktur 7 aus Polysilizium oder Wolfram, mit dem ein in die Isolationsschicht 6 geätztes Kontaktloch aufgefüllt wird. Anschließend wird die untere Elektrode 8 aufgebracht, z. B. durch Sputtern oder MOCVD einer etwa 30 nm dicken Pt-Schicht, und geeignet strukturiert. Anschlußstruktur 7 und Elektrode 8 können auch aus demselben Material, beispielsweise Polysilizium oder Wolfram, bestehen und gleichzeitig hergestellt werden. Danach wird durch Sputtern oder MOCVD eine Schicht aus Titancarbid als Barriereschicht 9 aufgebracht. Ihre Dicke beträgt vorzugsweise etwa 30 nm. Diese Barriereschicht 9 wird teilweise wieder entfernt, um die Isolation zum benachbarten Kondensator herzustellen, dabei bleibt jedoch mindestens die erste Elektrode an ihren freien Oberflächen mit der Barriereschicht bedeckt, um eine spätere O₂-Diffusion wirksam zu unterdrücken. In Figur 1 wurde die Barriereschicht 9 von der gesamten Oberfläche der Isolationsschicht 6 entfernt, die hierfür eingesetzte Fototechnik ist aber bezüglich ihrer Justierung unkritisch, solange die erste Elektrode 8 nicht freigelegt wird. Zum Ätzen der Titancarbid-Schicht können ähnliche Prozesse wie zum Ätzen einer Titannitridschicht verwendet werden, beispielsweise ein RIE-Prozess mit einem Ar/Cl₂-Gemisch, dem Sauerstoff zugesetzt wird, um den Kohlenstoff in flüchtiges CO₂ umzusetzen. Nach Herstellung der Barriereschicht 9 wird ein Hoch-ε-Dielektrikum 10 abgeschieden, wobei nun das Titancarbid während des Abscheidens als Barriere gegen eindiffundieren Sauerstoff wirkt und die Oxidation der Anschlußstruktur verhindert. Anschließend wird eine zweite Elektrode 11 beispielsweise aus Pt hergestellt

Eine Bitleitung des Halbleiterspeichers wird vorzugsweise so hergestellt, daß sie in der isolierenden Schicht 6 eingebettet liegt mit einem Kontakt zum SD-Gebiet 4 und im wesentlichen quer zu den Wortleitungen 5 verläuft, in diesem Fall also außerhalb der Zeichenebene.

Figur 2: Gemäß eines zweiten Ausführungsbeispieles ist die Barriereschicht 9 nicht über, sondern unter der ersten Elektrode, d. h. zwischen Anschlußstruktur 7 und erster Elektrode 8, angeordnet, der übrige Aufbau und das Herstellverfahren sind gleich. Die Bezugszeichen sind wie in FIG 1 gewählt.

Die Barriereschicht 9 muß mindestens die gesamte Grenzfläche zwischen Anschlußstruktur und erster Elektrode bedecken, d. h. mindestens die der ersten Elektrode zugewandte Oberfläche der Anschlußstruktur. Die in Figur 2 dargestellte Struktur kann besonders einfach dadurch hergestellt werden, daß die Barriereschicht gemeinsam mit der unteren Elektrode oder direkt anschließend strukturiert wird und eine zusätzliche Fotomaske nicht erforderlich ist. Die Barriereschicht entspricht in ihren lateralen Dimensionen dann der ersten Elektrode 8.

Um die Strukturierung der ersten Elektrode zu erleichtern, kann auch eine sehr dünne PE-Schicht 8, bspw. ca. 50 nm, hergestellt werden.

Figur 3: Gemäß einer dritten Ausführungsform stellt die Barriereschicht 9 selbst die erste Elektrode 8 dar. Sie wird über eine geeignete Anschlußstruktur 7 mit dem dotierten Gebiet 3 verbunden. Auf eine Platinabschiedung und - strukturierung zur ersten Elektrode wird verzichtet, das übrige Herstellungsverfahren ist gleich.

## Patentansprüche

1. Kondensator in einer integrierten Halbleiterschaltung
mit einer ersten Elektrode (8), die direkt oder über eine Anschlußstruktur (7) an ein dotiertes Gebiet (3) in einem Halbleitersubstrat (1) angeschlossen ist,
mit einer zweiten Elektrode (11)
mit einem Kondensatordielektrikum (10), das die erste und zweite Elektrode voneinander isoliert,
mit einer Barriereschicht (9), die im wesentlichen aus einer Verbindung zwischen einem Übergangselement und Bor oder Kohlenstoff besteht und unterhalb des Kondensatordielektrikums (10) angeordnet ist.

2. Kondensator nach Anspruch 1,
bei dem die Barriereschicht direkt unterhalb des Kondensatordielektrikums angeordnet ist und die gesamte Grenzfläche zwischen erster Elektrode (8) und Kondensatordielektrikum (10) bedeckt.

3. Kondensator nach Anspruch 1,
bei dem die Barriereschicht (9) die erste Elektrode (8) bildet.

4. Kondensator nach Anspruch 1,
bei dem die Barriereschicht (9) unterhalb der ersten Elektrode (8) angeordnet ist und die gesamte Grenzfläche zwischen erster Elektrode (8) und Anschlußstruktur (7) oder die gesamte Grenzfläche zwischen erster Elektrode (8) oder Anschlußstruktur (7) und dotiertem Gebiet (3) bedeckt.

5. Kondensator nach einem der Ansprüche 1 - 4,
bei dem das Kondensatordielektrikum aus einem dielektrischen oder ferroelektrischen Material mit einem Wert von ε > 100 besteht.

6. Kondensator nach einem der Ansprüche 1 - 2, 4 - 5
bei dem die erste Elektrode aus einem Pt-haltigen oder Ruhaltigen Material besteht.

7. Kondensator nach einem der Ansprüche 1 - 2, 4 - 5
bei dem die erste Elektrode aus Polysilizium oder Wolfram besteht.

8. Kondensator nach einem der Ansprüche 1 - 7,
mit einer Anschlußstruktur (7) aus Polysilizium oder Wolfram.

9. Kondensator nach einem der Ansprüche 1 - 2, 4 - 8,
bei dem die Barriereschicht (9) über die Grenzfläche hinausragt.

10. Kondensator nach einem der Ansprüche 1 - 9,
bei dem die Barriereschicht im wesentlichen aus einer etwa 30 nm dicken Titancarbid-Schicht besteht.

11. Kondensator nach einem der Ansprüche 1 - 10,
bei dem die Barriereschicht (9) im wesentlichen aus Chromborid (CrB) besteht.

12. Herstellverfahren für einen Kondensator in einer integrierten Halbleiterschaltung,
bei dem auf einem Substrat (1) eine erste Elektrode (8) erzeugt wird, die direkt oder über eine Anschlußstruktur (7) mit einem dotierten Gebiet (3) im Halbleitersubstrat (1) verbunden ist,
bei dem auf der ersten Elektrode (8) eine Barriereschicht (9) erzeugt wird, die im wesentlichen aus einer Verbindung zwischen einem Übergangselement und Bor oder Kohlenstoff besteht und die gesamte freiliegende Oberfläche der ersten Elektrode (8) bedeckt,
bei dem auf der Barriereschicht (9) ein Kondensatordielektrikum (10) erzeugt wird,
bei dem auf dem Kondensatordielektrikum (10) eine zweite Elektrode (11) erzeugt wird.

13. Herstellverfahren für einen Kondensator in einer integrierten Halbleiterschaltung,
bei dem auf einem Halbleitersubstrat (1) eine Anschlußstruktur (7) erzeugt wird, die mit einem dotierten Gebiet (3) im Substrat (1) verbunden ist,
bei dem auf der Anschlußstruktur (7) eine Barriereschicht (9) erzeugt wird, die im wesentlichen aus einer Verbindung zwischen einem Übergangselement und Bor oder Kohlenstoff besteht und die gesamte Grenzfläche der Anschlußstruktur (7) zur noch herzustellenden ersten Elektrode (8) bedeckt,
bei dem auf der Barriereschicht (9) eine erste Elektrode (8) erzeugt wird,
bei dem auf der ersten Elektrode (8) ein Kondensatordielektrikum (10) und eine zweite Elektrode (11) erzeugt werden.

14. Herstellverfahren für einen Kondensator in einer integrierten Halbleiterschaltung,
bei dem in einem Halbleitersubstrat (1) ein dotiertes Gebiet (3) erzeugt wird,
bei dem auf dem dotierten Gebiet (3) eine Barriereschicht (9) erzeugt wird, die im wesentlichen aus einer Verbindung zwischen einem Übergangselement und Bor oder Kohlenstoff besteht und die gesamte Grenzfläche des dotierten Gebietes (3) zu einer noch herzustellenden Anschlußstruktur (7) oder ersten Elektrode (8) bedeckt,
bei dem auf der Barriereschicht (9) eine erste Elektrode (8) oder eine Anschlußstruktur (7) mit einer darüberliegenden ersten Elektrode (8) erzeugt wird,
bei dem auf der ersten Elektrode (8) ein Kondensatordielektrikum (10) und eine zweite Elektrode (11) erzeugt werden.

15. Herstellungsverfahren nach einem der Ansprüche 12 - 14,
bei dem die Barriereschicht (9) ganzflächig aufgebracht wird und an den Stellen, an denen sie nicht an die erste Elektrode (8) grenzt, wieder entfernt wird.

16. Herstellverfahren nach einem der Ansprüche 13 - 15,
bei dem die Barriereschicht (9) unter Verwendung der ersten Elektrode (8) als Maske in einem Ätzprozess strukturiert wird.

17. Herstellverfahren nach einem der Ansprüche 12 - 16, bei dem das Kondensatordielektrikum (10) aus einem dielektrischen oder ferroelektrischen Material mit einem Wert von ε > 100 besteht.

18. Herstellverfahren nach einem der Ansprüche 12 - 17, bei dem die Barriereschicht (9) im wesentlichen aus Titancarbid oder Chromborid besteht.
